# EUROPÄISCHE PATENTSCHRIFT

(11) **EP 4 080 232 B1**
(45) Veröffentlichungstag und Bekanntmachung des Hinweises auf die Patenterteilung: **03.04.2024**
(21) Anmeldenummer: 22167061.5
(22) Anmeldetag: 07.04.2022
(51) Int. Cl.: G01R 33/032

(54) **MESSEINRICHTUNG UND VERFAHREN ZUR BESTIMMUNG MAGNETISCHER EIGENSCHAFTEN EINES MAGNETISIERBAREN PRÜFKÖRPERS**
MEASURING DEVICE AND METHOD FOR DETERMINING MAGNETIC PROPERTIES OF A MAGNETIZABLE TEST BODY
DISPOSITIF DE MESURE ET PROCÉDÉ DE DÉTERMINATION DES PROPRIÉTÉS MAGNÉTIQUES D'UN GABARIT D'ESSAI POUVANT ÊTRE MAGNÉTISÉ

(30) Priorität: 23.04.2021 DE 102021110527
(43) Veröffentlichungstag der Anmeldung: 26.10.2022
(73) Patentinhaber: BS & T Frankfurt am Main GmbH, 60438 Frankfurt am Main (DE)
(72) Erfinder: Sun, Jun Chao, 60438 Frankfurt am Main (DE)
(74) Vertreter: Habermann Intellectual Property Partnerschaft von Patentanwälten mbB

(56) Entgegenhaltungen:
- EP-B1- 0 365 622
- WO-A1-2020/089462
- DE-A1- 3 126 379
- DE-B3-102019 109 337

## Beschreibung

Die Erfindung betrifft eine Messeinrichtung zur Bestimmung magnetischer Eigenschaften eines magnetisierbaren Prüfkörpers gemäß Anspruch 1.

Die Erfindung betrifft auch ein Verfahren zur Erfassung magnetischer Eigenschaften eines magnetisierbaren Prüfkörpers gemäß Anspruch 9.

Die elektrischen Eigenschaften eines elektrischen Bauelements, das in einer mit elektrischer Energie versorgten Vorrichtung eingesetzt werden kann, sind von ausschlaggebender Bedeutung für das betreffende elektrische Bauelement. Dies gilt in gleicher Weise auch für elektronische Bauelemente und elektronische Schaltungen, die nachfolgend nicht gesondert erwähnt und aufgeführt werden, sondern vereinfachend und zusammenfassend als elektrische Schaltungen und elektrische Bauelemente bezeichnet werden.

Die Verwendung von weichmagnetischen Materialien gewinnt dabei zunehmend an Bedeutung für die Herstellung und Auslegung kompakter und verlustarmer elektrischer Bauelemente und insbesondere bei elektrischen Bauelementen im Bereich der Leistungselektronik, die für die Umformung elektrischer Energie in Bezug auf die Spannungsform, die Höhe von Spannung und Strom sowie auf die Frequenz verwendet werden können. Dabei sind in vielen Fällen das Sättigungsverhalten sowie ein während des Betriebs auftretender Leistungsverlust eines weichmagnetischen Materials wichtige Eigenschaften eines aus oder mit einem solchen weichmagnetischen Material hergestellten induktiven elektrischen Bauelements. Die induktiven Eigenschaften solcher weichmagnetischer Materialien, bzw. ganz allgemein von magnetischen Materialien werden deshalb mit verschiedenen Messverfahren und Messvorrichtungen erfasst, um möglichst geeignete Materialien für den jeweiligen Verwendungszweck eines elektrischen Bauelements identifizieren zu können.

Bei standardisierten Bauelementen oder Bauteilen, die in hohen Stückzahlen gefertigt werden, kann es von großer wirtschaftlicher Bedeutung sein, dass die für die Herstellung verwendeten Materialien und insbesondere weichmagnetische Materialien möglichst umfassend geprüft und getestet werden, um zu vermeiden, dass auf Grund von Materialfehlern eine größere Anzahl von teilweise aufwendig und kostenintensiv hergestellten Bauelementen nicht die gewünschten Eigenschaften aufweisen oder Funktionen ausüben können.

Aufgrund von vielen nichtlinearen Effekte eines elektromagnetischen Verhaltens der Bauteile können hohe Anforderungen an die messtechnischen Einrichtungen einer vor der Fertigstellung durchgeführten Materialprüfung oder einer nach der Fertigstellung durchgeführten Endkontrolle bestehen. Die dazu eingesetzten Messeinrichtungen müssen schnell und genau die relevanten Eigenschaften über den vollständigen Arbeitsbereich der zu messenden Bauteile ausmessen können, um wirtschaftlich die Qualität der hergestellten Bauteile zu gewährleisten.

Aus der Druckschrift DE 10 2018 127 378 B3 ist beispielsweise ein Messverfahren, eine Messvorrichtung und ein Datenträger mit Messdaten zur Ermittlung einer Induktivität eines elektrischen Bauelements bekannt. Bei dem Verfahren wird zur Ermittlung der Induktivität L des elektrischen Bauelement mit der Messvorrichtung in einem Anregungsschritt ein Hochstromimpuls erzeugt und durch das elektrische Bauelement geführt. Das elektronische Bauelement ist zusammen mit einem Referenzbauelement und mit mindestens einem Kondensator in einem elektrischen Schwingkreis angeordnet, der durch mindestens einen Hochstromimpuls zu elektrischen Schwingungen angeregt wird. In einem Messschritt werden über eine Messdauer hinweg elektrische Eigenschaften des elektrischen Bauelements gemessen und in einem Auswerteschritt aus den gemessenen elektrischen Eigenschaften die Induktivität L des elektrischen Bauelements ermittelt. Dabei werden in dem Messschritt ein Spannungsabfall U über das elektrische Bauelement sowie ein Referenzspannungsabfall U über das mit dem elektrischen Bauelement in Reihe geschaltete Referenzbauelement mit einer bekannten Referenzinduktivität L gemessen. In dem Auswerteschritt wird die Induktivität L des elektrischen Bauelements als Produkt der Referenzinduktivität L mit einem Proportionalitätsfaktor berechnet, der von dem gemessenen Spannungsabfall U und dem gemessenen Referenzspannungsabfall U abhängt.

Insbesondere bei aufwendig herzustellenden Bauelementen mit magnetischen Eigenschaften oder Funktionskomponenten ist es oftmals wirtschaftlich vorteilhaft, wenn bereits vor der Herstellung des Bauelements die magnetischen Eigenschaften der für die Herstellung vorgesehenen Materialien und Halbzeuge überprüft werden. Dadurch können minderwertige und den Qualitätsanforderungen nicht entsprechende Materialien und Halbzeuge aussortiert oder markiert werden, bevor sie zu einem fertigen Bauteil verarbeitet werden.

Ein oftmals verwendetes Halbzeug, bei dem es vorteilhaft ist, seine magnetischen Eigenschaften und Kenngrößen frühzeitig und vor einer Verarbeitung zu einem Bauteil zu kennen, ist ein Elektroblech. Elektrobleche sind dabei weichmagnetische Werkstoffe für Magnetkerne, beispielsweise in elektrischen Motoren oder Transformatoren. Dabei ist es für die bestimmungsgemäße Funktion beispielsweise des Transformators wichtig, die magnetische Gesamtverlustleistung des Transformatorkerns zu kennen, der regelmäßig aus mehreren geschichteten Elektroblechen aufgebaut ist. Denn ist der Transformator erst einmal hergestellt und aufgebaut, lassen sich einzelne Elektrobleche nicht mehr wirtschaftlich sinnvoll und zerstörungsfrei in dem Transformatorkern austauschen.

Aus der Druckschrift DE 10 2019 109 337 B3 ist eine Vorrichtung und ein Verfahren zum Messen magnetischer Eigenschaften eines ferromagnetischen Endlosbandes bekannt, aus dem in einem nachfolgenden Herstellungsschritt die Elektrobleche ausgestanzt werden können. Dabei werden mit dem Verfahren die magnetischen Eigenschaften eines Abschnitts des magnetisierbaren Endlosbands ermittelt, wobei die Vorrichtung eine primäre Spule zur Erzeugung eines magnetischen Feldes, ein geschlitztes Joch zum Führen des magnetischen Flusses und mehrere Spulen zum Messen des magnetischen Flusses umfasst. Die Messung des magnetischen Flusses mit den mehreren Spulen wird jedoch als nachteilig angesehen, denn ein magnetischer Fluss kann nur relativ ungenau mit Hilfe von Spulen oder anderen Sensoren - beispielsweise Hall-Sensoren - gemessen werden.

Es ist demnach eine Aufgabe der Erfindung, eine Messeinrichtung bereitzustellen, mit der die magnetischen Eigenschaften eines magnetisierbaren Prüfkörpers möglichst genau, schnell und zuverlässig gemessen werden können.

Die Aufgabe wird erfindungsgemäß dadurch gelöst, dass die Energieversorgungseinrichtung derart ausgebildet und eingerichtet ist, dass mit der Energieversorgungseinrichtung ein Hochstromimpuls erzeugt und durch die Messspulenwicklung geleitet werden kann, dass der Messspulenkern mindestens zwei beabstandet zueinander angeordnete Magnetflussdurchtrittsflächen aufweist, wobei der magnetisierbare Prüfkörper während eines Messvorgangs benachbart zu den mindestens zwei Magnetflussdurchtrittsflächen derart angeordnet werden kann, dass ein durch die Messspulenwicklung leitbarer Hochstromimpuls einen magnetischen Fluss durch den magnetisierbaren Messspulenkern und den magnetisierbaren Prüfkörper bewirken kann, und dass die Sensoreinrichtung derart ausgebildet und eingerichtet ist, dass mit der Sensoreinrichtung ein zeitlicher Verlauf von elektrischen Kenngrößen der Messspulenwicklung erfasst werden kann.

Der Hochstromimpuls kann dabei einen Spitzenwert von mehreren hundert oder tausend Ampere erreichen, wobei er eine Impulsdauer von einigen bis mehrere hundert Mikrosekunden haben sollte. Der von der Energieversorgungseinrichtung bereitgestellte Hochstromimpuls bewirkt in dem Messspulenkern einen magnetischen Fluss, der naturgemäß geschlossene Feldlinien aufweist. Die geschlossenen Feldlinien verlaufen einerseits konzentriert entlang und innerhalb des Messspulenkerns und andererseits außerhalb des Messspulenkerns. Ist der magnetisierbare Prüfkörper an den Magnetflussdurchtrittsflächen so angeordnet, dass die Feldlinien des magnetischen Flusses von der einen Magnetflussdurchtrittsfläche auf dem Weg zu der anderen Magnetflussdurchtrittsfläche weitgehend durch den magnetisierbaren Prüfkörper verlaufen können, ermöglicht er den Feldlinien des magnetischen Flusses einen Pfad mit einem geringeren magnetischen Widerstand, sodass die Feldlinien außerhalb des Messspulenkerns in dem magnetisierbaren Prüfkörper konzentriert werden können. Der auch in dem Prüfkörper konzentrierte magnetische Fluss des Messspulenkerns beeinflusst dadurch maßgeblich die magnetische Gesamtverlustleistung des Messspulenkerns und des Prüfkörpers und damit auch maßgeblich die elektrische Leistungsaufnahme der Messspulenwicklung.

Die Sensoreinrichtung erfasst die Strom- und Spannungsverläufe in der Messspulenwicklung, die durch den Hochstromimpuls erzeugt werden. Dabei werden die Strom- und Spannungsverläufe durch die Induktivität des Messspulenkerns und des magnetisierbaren Prüfkörpers messbar beeinflusst. Aus diesen elektrischen Kenngrößen und dem Verlauf des Hochstromimpulses können die Induktivität und damit die magnetischen Gesamtverluste bestimmen. Ein mögliches Verfahren zur Bestimmung der Induktivität der Messspulenwicklung ist aus der vorstehend zitierten Druckschrift DE 10 2018 127 378 B3 bekannt. Anhand einer Integration des Stromverlaufs durch die Messspulenwicklung mit einer Induktivität der Messspulenwicklung kann auf den magnetischen Fluss geschlossen werden. Eine Messung mit einem die beiden Magnetflussdurchtrittsflächen des Messspulenkerns verbindenden bzw. überbrückenden magnetisierbaren Prüfkörper kann mit einer weiteren Messung ohne den magnetisierbaren Prüfkörper oder mit einer weiteren Messung eines hinsichtlich seiner magnetischen Eigenschaften bereits bekannten Prüfkörpers verglichen werden und über den Vergleich die magnetischen Eigenschaften, die aus magnetischem Fluss, der magnetischen Feldstärke und dem transienten Stromverlauf bestimmbar sind, für den magnetisierbaren Prüfkörper ermittelt werden. Anhand einer derartigen Vergleichs- oder Referenzmessung ohne den magnetisierbaren Prüfkörper kann dementsprechend eine spezifische, magnetische Verlustleistung des magnetisierbaren Prüfkörpers bestimmt werden.

Erfindungsgemäß werden für die Ermittlung der magnetischen Eigenschaften wie beispielsweise der magnetischen Verluste bei einer Magnetisierung des magnetischen Prüfkörpers elektrische anstatt magnetische Kenngrößen zu erfassen. Die magnetischen Kenngrößen der Messspulenwicklung und des Messspulenkerns können ausgehend von den gemessenen elektrischen Kenngrößen mit Hilfe bekannter Zusammenhänge ermittelt bzw. berechnet werden.

Der Hochstromimpuls kann dabei transiente und periodische Signalanteile aufweisen, mit denen elektrische Charakteristika der Messspulenwicklung, wie beispielsweise die Induktivität oder der Widerstand, bestimmt werden können, aus denen dann die magnetischen Charakteristika des Messspulenkerns und des Prüfkörpers berechnet werden können. Aufgrund des Hochstromimpulses lassen sich sowohl Sättigungseffekte als auch ein Frequenzverhalten des Messspulenkerns und des Prüfkörpers ermitteln.

Mit einer ausreichend starken Energieversorgungseinrichtung kann der Prüfkörper wirtschaftlich schnell und gleichzeitig sehr präzise ausgemessen werden.

Gemäß einer vorteilhaften Ausgestaltung der Erfindung kann vorgesehen sein, dass der Messspulenkern aus einem Material mit hoher magnetischer Permeabilität besteht. Zweckmäßigerweise bestehen der magnetisierbare Prüfkörper und der magnetisierbare Messspulenkern jeweils aus einem Material mit unterschiedlicher magnetischer Permeabilität. Messtechnisch vorteilhaft ist, wenn der Messspulenkern eine sehr hohe Güte und damit geringe magnetische Verlustleistung aufweist, sodass die Verlustleistung des Prüfkörpers in dem Messvorgang stärker ins Gewicht fallen kann und leichter von den Verlusten des Messspulenkerns separiert werden kann.

Im Hinblick auf eine rasche Überprüfung und Messung einer großen Materialmenge ist es optional vorgesehen und vorteilhaft, dass der magnetisierbare Prüfkörper verlagerbar an den Magnetflussdurchtrittsflächen angeordnet ist. Ein entlang der Magnetflussdurchtrittsflächen verlagerbarer Prüfkörper kann dadurch abschnittweise vermessen werden. Die Verlagerung des Prüfkörpers entlang der Magnetflussdurchtrittsflächen kann dabei kontinuierlich mit einer gleichbleibenden Geschwindigkeit und somit unterbrechungsfrei erfolgen. Es ist ebenfalls möglich, den magnetisierbaren Prüfkörper in zeitlichen Abständen während einer ansonsten kontinuierlichen Verlagerung anzuhalten und eine Messung durchzuführen, um danach den magnetisierbaren Prüfkörper zu verlagern und an einer anderen Position bzw. für einen anderen Bereich des magnetisierbaren Prüfkörpers eine nachfolgende Messung durchzuführen. Die Magnetflussdurchtrittsflächen können abschnittsweise mit dem Prüfkörpers zusammenwirken, wobei eine gezieltere und detailliertere Vermessung des Prüfkörpers gewährleistet werden kann. Der magnetisierbare Prüfkörper kann dabei entweder nahe an den Magnetflussdurchtrittsflächen, jedoch mit einem Abstand zu den Magnetflussdurchtrittsflächen vorbeibewegt werden, oder aber zumindest während der Durchführung einer Messung an den Magnetflussdurchtrittsflächen anliegen und einen unmittelbaren Kontakt zu den Magnetflussdurchtrittsflächen aufweisen.

Als besonders vorteilhaft wird eine kontinuierliche Verlagerung des magnetisierbaren Prüfkörpers erachtet, wenn der magnetisierbare Prüfkörper jeweils aus einem Abschnitt eines auf einer Rolle aufgewickelten Endlosbands besteht, aus dem in einem nachfolgenden Herstellungsschritt beispielsweise einzelne Elektroblechzuschnitte hergestellt werden können, die beispielsweise zu einem Transformatorkern zusammengefügt werden.

Auf diese Weise lässt sich ein als Endlosband ausgestalteter Prüfkörper erfindungsgemäß abschnittsweise vermessen, wobei mit jeder einzelnen Messung die magnetischen Eigenschaften des jeweiligen Abschnitts bestimmt werden können. Anhand einer so vermessenen Übersicht über die magnetischen Eigenschaften des Endlosbands können die für einen nachfolgenden Herstellungsprozess geeigneten Bereiche identifiziert werden. Es können auch jeweils Elektroblechzuschnitte mit ähnlichen oder gleichen magnetischen Eigenschaften miteinander kombiniert und gemeinsam in einem Bauteil verwendet werden.

Einer Ausgestaltung des Erfindungsgedankens zufolge kann vorgesehen sein, dass der Messspulenkern u-förmig ausgestaltet ist. Bei einem u-förmigen Messspulenkern kann die Messspulenwicklung in einem zwischen zwei Schenkeln befindlichen Verbindungsabschnitt des Messspulenkerns angeordnet sein, während die Magnetflussdurchtrittsflächen jeweils durch Stirnseiten der beiden Schenkel gebildet werden, sodass ein länglicher Prüfkörper einen Abstand zwischen den zueinander beabstandeten Magnetflussdurchtrittsflächen überbrücken kann und die Feldlinien des magnetischen Flusses durch die Schenkel des u-förmigen Messspulenkerns und den die beiden Schenkel überbrückenden Prüfkörper verlaufen können. Dadurch entsteht ein magnetischer Kreis mit o-förmig verlaufenden geschlossenen Feldlinien durch den Messspulenkern und den Prüfkörper.

Ferner bietet sich ein u-förmiger Messspulenkern dahingehend an, dass die Magnetflussdurchtrittsflächen einfacher entlang flächiger Prüfkörper oder entlang einer ebenen Oberfläche der Prüfkörper geführt werden können, wobei der jeweilige Prüfkörper abschnittsweise vermessen werden kann.

Um die Messgenauigkeit zu erhöhen ist optional vorgesehen, dass die Magnetflussdurchtrittsflächen des Messspulenkerns eine Oberflächenrauigkeit mit einem Mittenrauwert von weniger als 5 µm, vorzugsweise von weniger als 0,5 µm aufweisen. Durch eine derart geringe Oberflächenrauigkeit kann ein unerwünschter Streufluss des durch die beiden Magnetflussdurchtrittsflächen hindurchtretenden Magnetfeldes ganz erheblich reduziert werden, wodurch die Messgenauigkeit für die magnetischen Eigenschaften des nahe oder auch unmittelbar anliegend an den Magnetflussdurchtrittsflächen angeordneten Prüfkörpers deutlich verbessert werden kann.

Gemäß einer besonders vorteilhaften Ausgestaltung des Erfindungsgedankens kann vorgesehen sein, dass die Messeinrichtung einen zweiten magnetisierbaren Messspulenkern aufweist, der mit seinen Magnetflussdurchtrittsflächen gegenüberliegend zu den Magnetflussdurchtrittsflächen des von der Messspulenwicklung umgriffenen ersten magnetisierbaren Messspulenkerns angeordnet ist, wobei der magnetisierbare Prüfkörper zwischen den Magnetflussdurchtrittsflächen der zwei magnetisierbaren Messspulenkerne angeordnet ist, sodass der durch die Messspulenwicklung hervorgebrachte magnetischer Fluss durch die zwei magnetisierbaren Messspulenkerne und den magnetisierbaren Prüfkörper wirken kann.

Nach dieser Ausgestaltung kann eine bessere Symmetrie des magnetischen Flusses und dessen Feldlinien erreicht werden, da die Feldlinien durch die zwei Messspulenkerne und den zwischen den zwei Messspulenkernen angeordneten Prüfkörper führen können. Zusätzlich kann der zweite Messspulenkern ebenfalls eine Messspulenwicklung aufweisen, die einen zu dem ersten magnetischen Fluss phasengleichen zweiten magnetischen Fluss bewirken kann. Dadurch kann eine höhere Eindringtiefe der magnetischen Flüsse in den Prüfkörper erreicht werden, womit optional die Messgenauigkeit erhöht werden kann.

Eine zusätzliche Erfassung und Bestimmung der magnetischen Eigenschaften kann dadurch erreicht werden, dass die Messeinrichtung eine magnetooptische Sensoreinrichtung aufweist, mit welcher eine Magnetisierung des magnetisierbaren Prüfkörpers optisch erfasst werden kann. Mit einer magnetooptischen Sensoreinrichtung ist es möglich, die Magnetisierung eines Oberflächenbereichs des magnetisierbaren Prüfkörpers optisch zu erfassen. Dabei kann beispielsweise der magnetooptische Kerr-Effekt ausgenutzt werden, demzufolge eine Polarisierung von Licht, welches von einer Oberfläche des Prüfkörpers reflektiert wird, von der Magnetisierung des Prüfkörpers im Bereich der Oberfläche abhängt. Die zusätzliche Verwendung einer magnetooptischen Sensoreinrichtung kann beispielsweise für Zwecke der Qualitätssicherung vorteilhaft sein, wenn die von der Sensoreinrichtung gemessenen elektrischen Kenngrößen, die für eine vorgegebene räumliche Anordnung des Prüfkörpers relativ zu den Magnetflussdurchtrittsflächen erfasst wurden, mit den mit der magnetooptischen Sensoreinrichtung erfassten Messwerten oder Abbildungen abgeglichen werden können. Die magnetooptische Sensoreinrichtung ermöglicht eine zusätzliche und räumlich oftmals hoch auflösende Ermittlung der Magnetflussdichte des Prüfkörpers.

Für eine möglichst effektive Ausnutzung der Messspulenwicklung kann gemäß einer Ausgestaltung des Erfindungsgedankens vorgesehen sein, dass die Messspulenwicklung aus mehradrigen Leitungen besteht, wobei die Leitungen gegeneinander elektrisch isoliert sind. Eine Isolierung der Leitungen kann dabei beispielsweise durch einen Lack erfolgen, der auf einer Oberfläche jede Leitung abgelagert ist, sodass alle Leitungen zueinander entlang der Messspulenwicklung elektrisch nicht verbunden sind. Danach können durch den Hochstromimpuls bedingte parasitäre Effekte, wie beispielsweise ein Skin-Effekt oder ein Proximity-Effekt in der Messspulenwicklung, reduziert werden, sodass eine bestmögliche Querschnittausnutzung der Messspulenwicklung erreichbar ist.

Es wird als eine weitere Aufgabe der vorliegenden Erfindung angesehen, ein Verfahren bereitzustellen, mit welchem die magnetischen Eigenschaften eines magnetisierbaren Prüfkörpers möglichst genau, schnell und zuverlässig ermittelt werden können.

Die Aufgabe wird mit einem erfindungsgemäßen Verfahren gelöst, wobei in einem Messschritt der magnetisierbare Prüfkörper in einer Messposition relativ zu einem Messspulenkern mit einer den Messspulenkern umgreifenden Messspulenwicklung einer Messeinrichtung angeordnet wird und mit einer Energieversorgungseinrichtung, die mit der Messeinrichtung elektrisch leitend verbunden ist, durch die Messspulenwicklung der Messeinrichtung ein von der Energieversorgungseinrichtung bewirkter Hochstromimpuls geführt wird, wobei mindestens ein zeitlicher Strom- und Spannungsverlauf durch die Messspulenwicklung erfasst werden, und wobei in einem nachfolgenden Ermittlungsschritt eine Kenngröße für eine magnetische Eigenschaft des Prüfkörpers anhand des mindestens einen erfassten Strom- und Spannungsverlaufs ermittelt wird, indem der mit dem magnetisierbaren Prüfkörper erfasste Strom- und Spannungsverlauf für den magnetisierbaren Prüfkörper und die Messeinrichtung mit dem jeweiligen Verlauf eines Referenzstromverlaufs und Referenzspannungsverlaufs verglichen wird, der in einem Referenzmessschritt mit der Messeinrichtung für einen Referenzkörper gemessen wurde, wobei aus einer Differenz zwischen dem gemessenen Strom- und Spannungsverlauf und dem Referenzstrom- und Referenzspannungsverlauf die Kenngröße für die magnetische Eigenschaft des Prüfkörpers ermittelt wird.

Der Referenzmessschritt kann beispielsweise für Luft oder Vakuum als Referenzkörper durchgeführt werden, sodass der Referenzstrom- und Referenzspannungsverlauf ausschließlich durch die Induktivität der Messeinrichtung beeinflusst werden. Der Referenzmessschritt kann auch für einen von dem Prüfkörper hinsichtlich des Materials oder der Formgebung abweichenden Referenzkörper durchgeführt werden, wobei in diesem Fall wie bei dem Messschritt mit dem Prüfkörper die kombinierte Induktivität der Messeinrichtung und des Referenzkörpers den Verlauf des Referenzstromverlaufs und des Referenzspannungsverlaufs beeinflusst.

Sowohl bei dem Messschritt als auch bei dem Referenzmessschritt werden zweckmäßigerweise alle erfassten elektrischen Kenngrößen und insbesondere die Strom- und Spannungsverläufe abgespeichert. Ausgehend davon können beispielsweise die magnetischen Verluste des Prüfkörpers berechnet werden.

Der Referenzmessschritt kann beliebig oft vor einem serienmäßigen Betrieb der erfindungsgemäßen Messeinrichtung durchlaufen werden, sodass genug Strom- und Spannungsverläufe des Messspulenkerns ohne den Prüfkörper und gegebenenfalls in Kombination mit verschiedenen Referenzkörpern zur Verfügung stehen, um die erfindungsgemäße Messeinrichtung zu kalibrieren und eine große Menge an Referenzdaten zu erheben. Der Referenzmessschritt kann optional auch in periodischen Zeitabständen wiederholt werden, um eine stabile Qualität der Ergebnisse der erfindungsgemäßen Messeinrichtung gewährleisten zu können.

Einer vorteilhaften Ausgestaltung des erfindungsgemäßen Verfahrens zufolge kann vorgesehen sein, dass in einem Verlagerungsschritt der magnetisierbare Prüfkörper relativ zu Magnetflussdurchtrittsflächen des Messspulenkerns verlagert wird. Die beiden Magnetflussdurchtrittsflächen des Messspulenkerns sind zweckmäßigerweise ebenflächig und in einer gemeinsamen Messebene oder zumindest parallel zueinander ausgerichtet. Der Prüfkörper kann parallel zu der Messebene oder mit einer Oberfläche des Prüfkörpers entlang der Messebene der Magnetflussdurchtrittsflächen verlagert werden. Dadurch können auch ein kontinuierlicher Messablauf und eine kontinuierliche, abschnittsweise Vermessung des magnetisierbaren Prüfkörpers ermöglicht werden.

Es hat sich gezeigt, dass das erfindungsgemäße Verfahren besonders vorteilhaft für dünnwandige Metallbleche durchgeführt werden kann, die für die Herstellung von magnetischen oder elektromagnetischen Bauteilen wie beispielsweise Transformatoren vorgesehen sind. Dabei werden rascherstarrte amorphe oder nanokristalline Metallbleche mit einer Dicke von weniger als 0,1 mm, vorzugsweise von weniger als 0,03 mm als Halbzeuge mit besonders günstigen Eigenschaften für die Herstellung von magnetischen oder elektromagnetischen Bauteilen angesehen. Bei günstigen Bedingungen können auch derartige Metallbleche mit einer Dicke von etwa 5 µm hergestellt und anschließend vermessen beziehungsweise überprüft werden. Derartige Bleche aus Metall oder aus einer geeigneten Legierung können als Endlosband konfektioniert werden und vor der Herstellung einzelner Zuschnitte für Bauteile mit dem erfindungsgemäßen Verfahren überprüft werden, indem das Metallband kontinuierlich an der Messeinrichtung vorbeigeführt und dabei die magnetischen Eigenschaften des Metallbandes ermittelt bzw. zumindest stichprobenartig überprüft werden.

In einem Verlagerungsschritt kann der Prüfkörper kontinuierlich oder aber schrittweise verlagert werden.

Mit einer kontinuierlichen Verlagerung werden zahlreiche einzelne Messungen innerhalb kurzer Zeit ermöglicht. Bei einer schrittweisen Verlagerung kann der Prüfkörper in diskreten Abständen und damit innerhalb definiert vorgegebener Bereiche vermessen werden.

Gemäß einer besonders vorteilhaften Ausgestaltung des Erfindungsgedankens kann vorgesehen sein, dass der von der Energieversorgungseinrichtung erzeugte und durch die Messspulenwicklung geführte Hochstromimpuls so vorgegeben wird, dass ein in dem magnetisierbaren Prüfkörper durch den Hochstromimpuls erzeugter magnetischer Fluss an eine magnetische Sättigung des magnetisierbaren Prüfkörpers angepasst ist. Eine möglichst hohe Magnetisierung des magnetisierbaren Prüfkörpers während einer Messung ermöglicht eine hohe Messgenauigkeit. Dabei wird vorzugsweise die Energie des Hochstromimpulses so an den magnetisierbaren Prüfkörper angepasst, dass durch den Hochstromimpuls ein derartiger magnetischer Fluss in dem Prüfkörper erzeugt und der Prüfkörper dadurch so magnetisiert wird, dass gerade eine magnetische Sättigung des von dem Magnetfeld zwischen den beiden Magnetflussdurchtrittsfläche erfassten Bereichs des Prüfkörpers bewirkt wird. Nach Möglichkeit soll dabei keine oder nur ein geringer Anteil überschüssiger Energie in den magnetisierbaren Prüfkörper eingeleitet werden, der dann beispielsweise in kinetische Energie umgewandelt wird und Vibrationen des Prüfkörpers bewirkt. Die Energie des Hochstromimpulses kann zweckmäßigerweise mit einer Genauigkeit von weniger als 1 Joule vorgegeben und an die angestrebten Messbedingungen angepasst werden.

Optional kann auch eine Verlagerungs- oder Vermessungsgeschwindigkeit des Prüfkörpers derart vorgegeben werden, dass nur wenige beabstandet zueinander angeordnete Abschnitte des Prüfkörpers gezielt vermessen werden. Dadurch können eine große Anzahl von Prüfkörpern innerhalb eines kurzen Zeitraums überprüft werden und anhand der wenigen Messungen abgeschätzt werden, ob die magnetischen Eigenschaften des Prüfkörpers den Vorgaben entsprechen. Das ist vorteilhaft, da die Zeit für eine vollständige Vermessung jedes Prüfkörpers gespart werden kann und eine Produktionsgeschwindigkeit erhöht werden kann.

Optional kann nach einer besonders vorteilhaften Ausgestaltung des erfindungsgemäßen Verfahrens vorgesehen sein, dass in einem Magnetfelderfassungsschritt eine mit einer magnetooptischen Sensoreinrichtung erfassbare magnetische Flussdichte des Magnetfeldes an einer Oberfläche des Prüfkörpers erfasst wird. Der Magnetfelderfassungsschritt kann dabei effizient parallel zum Messschritt durchgeführt werden, da die Messeinrichtung in dieser Zeitspanne ebenfalls die Messspulenwicklung vermisst. In dem Magnetfelderfassungsschritt kann eine Magnetfeld-Kamera mit ihren magnetooptischen Sensoren die magnetische Flussdichte des Magnetfeldes erfassen.

Mit einer geeigneten magnetooptischen Sensoreinrichtung können auch eine magnetische Domänenstruktur beziehungsweise weisssche Bezirke an einer Oberfläche des Prüfkörpers sichtbar gemacht werden. In Abhängigkeit von der Art der Messung können dabei statische Abbildungen oder aber dynamische Abbildungen erzeugt werden, mit welchen auch Domänenwandverschiebungen oder Domänenrotationen während einer Magnetisierung des magnetisierbaren Prüfkörpers sichtbar gemacht und ausgewertet werden können, um beispielsweise das Verlustverhalten des magnetisierbaren Prüfkörpers besser erfassen und ermitteln zu können. Die Magnetisierung kann dabei erfindungsgemäß auf verschiedene Arten erfolgen. So kann beispielsweise auch eine Gleichstromvormagnetisierung vorgenommen werden, bevor der Hochstromimpuls erzeugt wird.

Die Erfindung betrifft auch ein Messsystem zur Ermittlung einer magnetischen Eigenschaft des magnetisierbaren Prüfkörpers mit der erfindungsgemäßen Messeinrichtung, wobei das Messsystem eine Messverarbeitungseinrichtung aufweist, die mit der Messeinrichtung signalübertragend verbunden ist und mit der das erfindungsgemäße Verfahren durchführbar ist. Die Messverarbeitungseinrichtung kann dazu beispielsweise einen Computer oder einen Laptop aufweisen, auf welchem eine in geeigneter Weise programmierte Auswertesoftware aktiviert werden kann.

In den Speichereinrichtungen des Computers oder des Laptops können die berechneten Messspulenkern-, Prüfkörper- und Gesamtverlustleistungen und weitere charakteristische Messdaten der vergangen Messdurchgänge gespeichert werden, die zur Qualitätssicherung erforderlich sein können.

Nachfolgend zeigen schematische Darstellungen exemplarische Ausgestaltungen der Erfindung. Es zeigt:
Fig. 1 ein Messsystem zur Messung magnetischer Eigenschaften und Kenngrößen eines magnetisierbaren Prüfkörpers mit einer Messeinrichtung, einer Energieversorgungseinrichtung sowie einer Messverarbeitungseinrichtung,
Fig. 2 zwei u-förmige Messspulenkerne mit einer Messspulenwicklung und einem zwischen ihnen angeordneten Prüfkörper,
Fig. 3 einen magnetisierbaren Prüfkörper mit einer Messspulenwicklung, einem Messspulenkern und einer Magnetfeld-Kamera,
Fig. 4 einen sequentiellen Programmablaufplan des erfindungsgemäßen Verfahrens,
Fig. 5 ein durch ein erfindungsgemäßes Verfahren berechnetes Kennfeld der Messspulenwicklung und
Fig. 6 eine alternative Ausgestaltung des Messsystems mit einem Stromrichter als Energieversorgungseinrichtung.

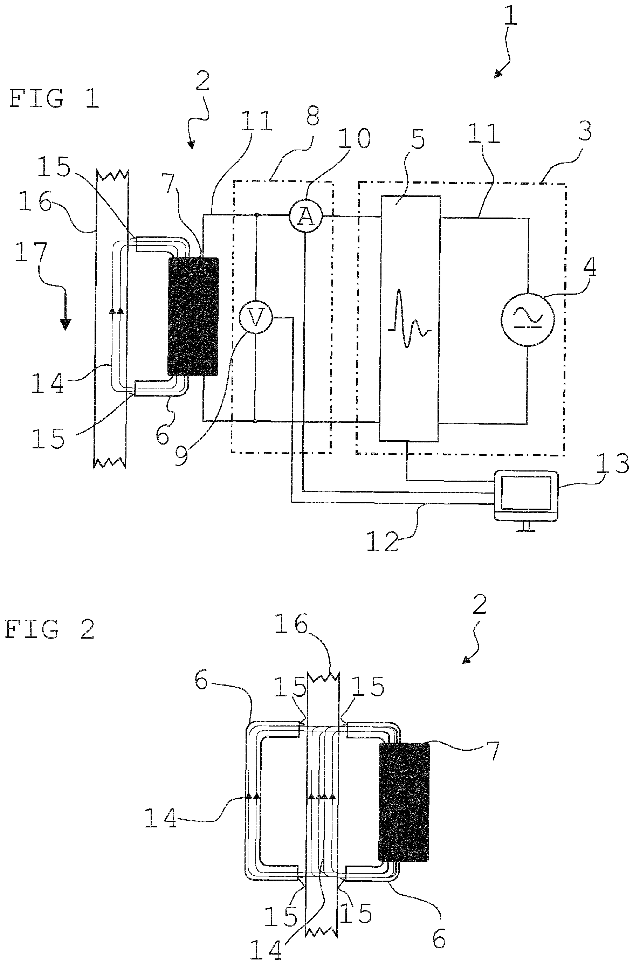

In Figur 1 ist gezeigt ein erfindungsgemäßes Messsystem 1 mit einer erfindungsgemäßen Messeinrichtung 2 sowie einer Energieversorgungseinrichtung 3. Die Energieversorgungseinrichtung 3 umfasst eine Energiequelle 4, die sowohl Gleich- als auch Wechselspannungen bereitstellen kann, und einen Pulsgenerator 5, der von der Energiequelle 4 versorgt den Hochstromimpuls generieren kann.

Die Messeinrichtung 2 hingegen umfasst einen u-förmigen Messspulenkern 6, der von einer Messspulenwicklung 7 umgriffen ist, und eine Sensoreinrichtung 8, die eine Spannungsmessung 9 und eine Strommessung 10 aufweist, wobei die Sensoreinrichtung 8 geeignet dazu ist, die elektrischen Kenngrößen der Messspulenwicklung 7 zu erfassen. Die Messeinrichtung 2 und die Energieversorgungseinrichtung 3, konkret der Pulsgenerator 5, sind über elektrische Leitungen 11 miteinander verbunden, sodass der von dem Pulsgenerator 5 erzeugte Hochstromimpuls auf die Messspulenwicklung 7 wirken kann, während die Sensoreinrichtung 8 die elektrischen Kenngrößen erfassen kann.

Ferner sind die Strom- 10 und Spannungsmessung 9 über Signalleitungen 12 mit einer Messverarbeitungseinrichtung in Ausgestaltung eines Computers 13 verbunden, sodass die Strom- und Spannungsverläufe an der Messspulenwicklung 7 zuverlässig verarbeitet und abgespeichert werden können.

Wird ein Hochstromimpuls der Messspulenwicklung 7 eingeprägt, bildet sich im Messspulenkern 6 ein magnetischer Fluss 14 aus, der entlang des Messspulenkerns 6 verläuft und aus zwei Magnetflussdurchtrittsflächen 15 aus- und wieder eintritt.

Wird in die Nähe der Magnetflussdurchtrittsflächen 15 ein Prüfkörper 16 angeordnet, verläuft der magnetische Fluss 14 auch durch den Prüfkörper 16. In einer Referenzmessung können die magnetischen Verluste des Messspulenkerns 6 ermittelt werden, wenn kein Prüfkörper 16 an den Magnetflussdurchtrittsflächen 15 angeordnet ist. Wobei in einem nachfolgenden Messdurchlauf, der mit dem an den Magnetflussdurchtrittsflächen 15 anliegendem Prüfkörper 16 durchgeführt wird, die Gesamtverlustleistung von dem Prüfkörper 16 und dem Messspulenkern 6 ermittelt werden können. Mit Hilfe mathematischer Berechnung können im Nachgang die beiden Verlustleistungen, eine Verlustleistung des Prüfkörpers 16 sowie des Messspulenkerns 6, separiert werden, womit anschließend die magnetische Qualität des Prüfkörpers 16 bewertet werden kann.

Wie in Figur 1 gezeigt, ist der Prüfkörper 16, der wesentlich länger entlang einer Verlagerungsrichtung 17 ausgestaltet ist als der Messspulenkern 6, entlang der Verlagerungsrichtung 17 verlagerbar. Dadurch kann der längere Prüfkörper 16 abschnittsweise mit einer Bereichsauflösung in einer Länge des Messspulenkerns 6 bezüglich seiner magnetischen Verlustleistung vermessen werden.

Die indirekte Messung des magnetischen Flusses 14 über die mit der Sensoreinrichtung 8 erfassten elektrischen Kenngrößen kann üblicherweise genauer, zuverlässiger oder kostengünstiger erfolgen als eine direkte Messung des magnetischen Flusses 14 über Magnetfeldsensoren oder dergleichen. Weiter lassen sich in dem Computer 13 weiterführende und komplexe Berechnungen und Visualisierungen durchführen, sodass mehr als nur der magnetische Fluss 14 direkt ausgemessen und bewertet werden kann.

In Figur 2 ist eine alternative Ausgestaltung eines Bereichs um den Prüfkörper 16 dargestellt. In dieser schematischen Darstellung ist der Prüfkörper 16 einerseits ebenfalls an den zwei Magnetflussdurchtrittsflächen 15 des Messspulenkerns 6 angeordnet, andererseits weist die Messeinrichtung 2 einen zweiten u-förmigen Messspulenkern 6 auf, der an der linken Seite des Prüfkörpers 16 angeordnet ist. Das kann von Vorteil sein, denn dadurch kann sich der von dem Hochstromimpuls erzeugte magnetische Fluss 14 besser und gleichmäßiger in dem Prüfkörper 16 verteilen, da der magnetische Fluss 14 ebenfalls durch den zweiten Messspulenkern 6 fließen kann.

Ferner kann der zweite Messspulenkern 6 auch eine eigene Messspulenwicklung 7 aufweisen, die einen zusätzlichen Anteil des magnetischen Flusses 14 in dem Prüfkörper 16 erzeugen könnte, was aber in dieser Darstellung nicht explizit gezeigt ist.

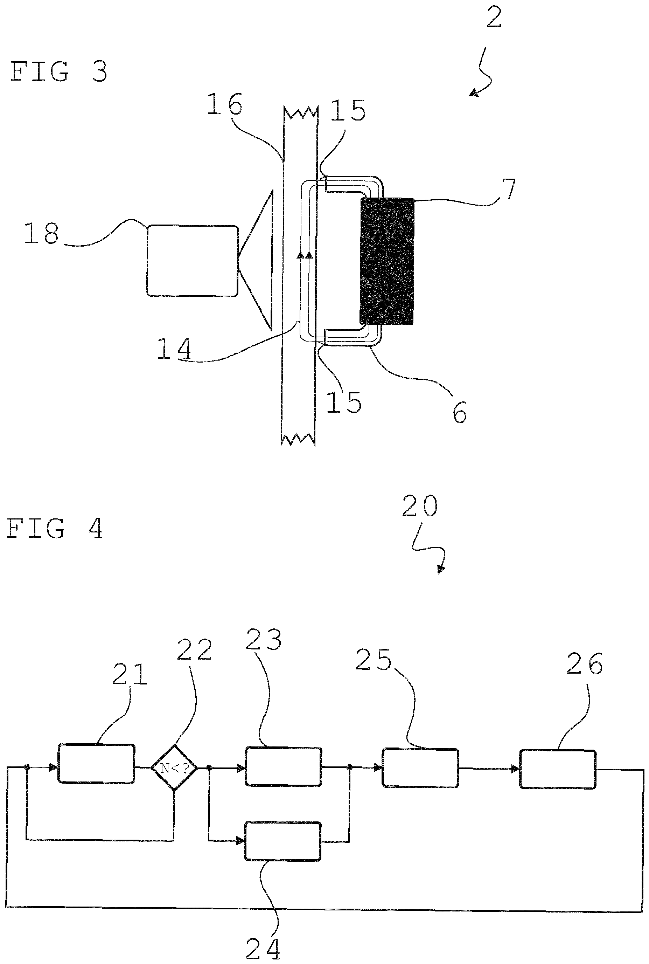

In Figur 3 ist eine weitere Ausgestaltung der Messeinrichtung 2 gezeigt, in der der zweite Messspulenkern 6 durch eine magnetooptische Sensoreinrichtung 18 ersetzt wurde. Mit der magnetooptischen Sensoreinrichtung 18, beispielsweise eine Magnetfeld-Kamera, kann die Messeinrichtung 2 eine magnetische Flussdichte auf einer Oberfläche 19 des Prüfkörpers 16 erfassen, die von dem magnetischen Fluss 14 innerhalb des Prüfkörpers bewirkt wird.

Mit der magnetooptischen Sensoreinrichtung 18 kann eine Verteilung, eine Gleichmäßigkeit und eine Intensität der magnetischen Flussdichte auf der erfassten Oberfläche 19 bestimmt werden, was von Vorteil für eine kontinuierliche Qualitätssicherung sein kann.

In Figur 4 ist ein Programmablaufplan des erfindungsgemäßen Verfahrens 20 schematisch dargestellt. Dabei beginnt ein Messdurchgang des Verfahrens 20 mit einem Referenzmessschritt 21, in dem die Strom- und Spannungsverläufe mittels der Sensoreinrichtung 8 erfasst werden, ohne dass ein Prüfkörper 16 an den Magnetflussdurchtrittsflächen 15 des Messspulenkerns 6 angeordnet ist. Wobei der Referenzmessschritt 21 mittels einer Verzweigung 22 entsprechend einer Voreinstellung auch mehr als einmal durchgeführt werden kann. Das mehrmalige Durchführen des Referenzmessschritts 21 ermöglicht eine zuverlässige Mittelwertbildung der durch die Sensoreinrichtung 8 erfassten elektrischen Kenngrößen.

Nachfolgend werden parallel ein Messschritt 23 und ein Magnetfelderfassungsschritt 24 durchgeführt. In dem Messschritt 23 wird die Messspulenwicklung 7 der Messeinrichtung 2 mit dem Hochstromimpuls beaufschlagt und die elektrischen Kenngrößen mittels der Sensoreinrichtung 8 und deren Strom- 10 und Spannungsmessung 9 erfasst. Zeitgleich erfasst eine Magnetfeld-Kamera 18 in dem Magnetfelderfassungsschritt 24 die magnetische Flussdichte der Oberfläche 19 des Prüfkörpers 16.

In einem nachfolgenden Berechnungsschritt 25 werden anhand der erfassten Messdaten und Kenngrößen die jeweiligen Verluste des Messspulenkerns 6 und des Prüfkörpers 16 berechnet, fusioniert und/oder visualisiert.

In einem letzten Verlagerungsschritt 26 wird der Prüfkörper entlang der Verlagerungsrichtung 17 um einen voreingestellten Wert automatisiert verlagert, sodass ein neuer Abschnitt des Prüfkörpers 16 gemäß des erfindungsgemäßen Verfahrens 20 vermessen werden kann.

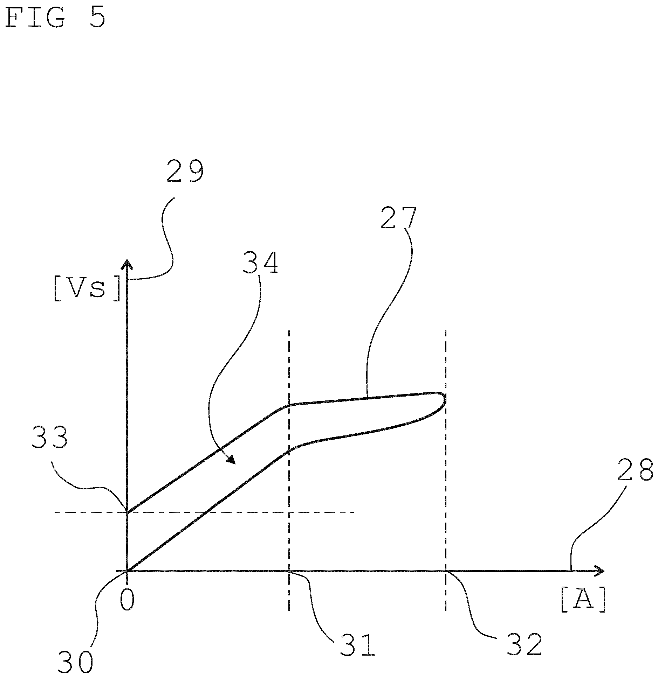

In Figur 5 ist ein durch den Hochstromimpuls bewirkter und durch die Messeinrichtung 2 erfasster sowie berechneter Funktionsgraph 27 schematisch dargestellt. Entlang einer Abszissenachse 28 ist eine von der Sensoreinrichtung 8 und deren Strommessung 10 erfasste Stromstärke durch die Messspulenwicklung 7 in Ampere [A] aufgetragen, wobei entlang einer Ordinatenachse 29 integrierte Spannungs-Zeit-Werte in Voltsekunde [Vs] der von einer Sensoreinrichtung 8 und deren Spannungsmessung 9 erfassten Spannung an der Messspulenwicklung 7 aufgetragen sind.

Der Verlauf des Funktionsgraphen 27 beginnt in einem Koordinatenursprung 30 und steigert sich linear bis zu einem Sättigungsstromwert 31, nach dem der Verlauf des Funktionsgraphen 27 erheblich abflacht, da die Messspulenwicklung 7 gesättigt ist, bis an einem Spitzenstromwert 32 der Verlauf des Funktionsgraphen 27 umkehrt, da der Hochstromimpuls ebenfalls abklingt. Der abklingende Hochstromimpuls bewirkt einen in umgekehrter Reihenfolge sinkenden Verlauf des Funktionsgraphen 27, der nach dem Abklingen des Hochstromimpulses an einem Restmagnetisierungswert 33 stopp macht.

Eine eingeschlossene Energiefläche 34 des Funktionsgraphen 27 weist die Einheit einer Energie (VAs) auf, sodass über die eingeschlossene Energiefläche 34 auf die magnetischen Verluste des durchlaufenen Messdurchgangs geschlossen werden kann. Nach mehreren Messdurchgängen, mit und ohne dem Prüfkörper 16, können die ermittelten Gesamtverlustleistungen rechentechnisch anteilig dem Prüfkörper 16 und dem Messspulenkern 6 zugeordnet werden.

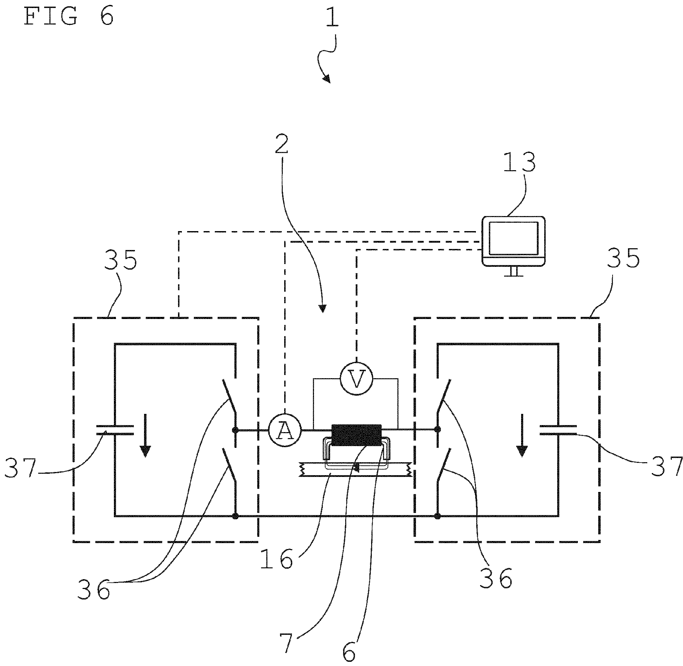

In Figur 6 ist eine alternative Ausgestaltung des erfindungsgemäßen Messsystems 1 mit der Messeinrichtung 2, der Energieversorgungseinrichtung 3 und dem Computer 13 dargestellt. Die Energieversorgungseinrichtung 3 weist im Unterschied zu den vorstehenden Figuren keine gesonderte Energiequelle 4 und keinen gesonderten Pulsgenerator 5 auf. Beide sind nunmehr in einem Stromrichter 35 integriert.

Der Hochstromimpuls wird in der gezeigten Darstellung von vier zu einer H-Brückenschaltung verschalteten Leistungshalbleiterschaltern 36 bereitgestellt, wobei die Energie für den Hochstromimpuls aus einem Gleichspannungs-Zwischenkreis 37 gezogen werden kann, der seinerseits durch eine nicht dargestellte, externe Energiequelle, beispielsweise eine Batterie oder einen Gleichrichter, geladen werden sollte.

Durch entsprechende Schalterstellungen der Leistungshalbleiterschalter 36 lassen sich unterschiedlich geformte Hochstromimpulse generieren. Die Leistungshalbleiterschalter 36 können hierbei Thyristoren, IGBTs oder auch MOSFETs sein.

### BEZUGSZEICHENLISTE

1. Messsystem
2. Messeinrichtung
3. Energieversorgungseinrichtung
4. Energiequelle
5. Pulsgenerator
6. Messspulenkern
7. Messspulenwicklung
8. Sensoreinrichtung
9. Spannungsmessung
10. Strommessung
11. Elektrische Leitung
12. Signalleitungen
13. Messverarbeitungseinrichtung / Computer
14. Magnetischer Fluss
15. Magnetflussdurchtrittsflächen
16. Prüfkörper
17. Verlagerungsrichtung
18. magnetooptische Sensoreinrichtung
19. Oberfläche
20. Verfahren
21. Referenzmessschritt
22. Verzweigung
23. Messschritt
24. Magnetfelderfassungsschritt
25. Berechnungsschritt
26. Verlagerungsschritt
27. Funktionsgraph
28. Abszissenachse
29. Ordinatenachse
30. Koordinatenursprung
31. Sättigungsstromwert
32. Spitzenstromwert
33. Restmagnetisierungswert
34. Eingeschlossene Energiefläche
35. Stromrichter
36. Leistungshalbleiter
37. Gleichspannungs-Zwischenkreis

## Patentansprüche

1. Messeinrichtung (2) zur Bestimmung von magnetischen Eigenschaften eines magnetisierbaren Prüfkörpers (16), wobei die Messeinrichtung (2) eine Messspulenwicklung (7) , einen Messspulenkern (6) und eine Energieversorgungseinrichtung (3) aufweist, wobei die Messspulenwicklung (7) den Messspulenkern (6) umgreift und von der Energieversorgungseinrichtung (3) mit elektrischer Energie versorgt werden kann, und wobei die Messeinrichtung (2) eine Sensoreinrichtung (8) aufweist, die derart ausgebildet und eingerichtet ist, mindestens eine Kenngröße für die magnetischen Eigenschaften des magnetisierbaren Prüfkörpers (16) zu erfassen, **dadurch gekennzeichnet, dass** die Energieversorgungseinrichtung (3) derart ausgebildet und eingerichtet ist, dass mit der Energieversorgungseinrichtung (3) ein Hochstromimpuls erzeugt und durch die Messspulenwicklung (7) geleitet werden kann, dass der Messspulenkern (6) mindestens zwei beabstandet zueinander angeordnete Magnetflussdurchtrittsflächen (15) aufweist, wobei der magnetisierbare Prüfkörper (16) während eines Messvorgangs benachbart zu den mindestens zwei Magnetflussdurchtrittsflächen (15) derart angeordnet werden kann, dass der durch die Messspulenwicklung (7) leitbarer Hochstromimpuls einen magnetischen Fluss (14) durch den Messspulenkern (6) und den magnetisierbaren Prüfkörper (16) bewirken kann, und dass die Sensoreinrichtung derart ausgebildet und eingerichtet ist, dass mit der Sensoreinrichtung (8) ein zeitlicher Verlauf von elektrischen Kenngrößen der Messspulenwicklung (7) erfasst werden kann.

2. Messeinrichtung (2) nach Anspruch 1, **dadurch gekennzeichnet, dass** der Messspulenkern (6) aus einem Material mit hoher magnetischer Permeabilität besteht.

3. Messeinrichtung (2) nach Anspruch 1 oder 2, **dadurch gekennzeichnet, dass** der magnetisierbare Prüfkörper (16) verlagerbar an den Magnetflussdurchtrittsflächen (15) angeordnet ist.

4. Messeinrichtung (2) nach einem der vorstehenden Ansprüche, **dadurch gekennzeichnet, dass** der Messspulenkern (6) u-förmig ausgestaltet ist.

5. Messeinrichtung (2) nach einem der vorstehenden Ansprüche, **dadurch gekennzeichnet, dass** die Magnetflussdurchtrittsflächen (15) des Messspulenkerns (6) eine Oberflächenrauigkeit mit einem Mittenrauwert von weniger als 5 µm, vorzugsweise von weniger als 0,5 µm aufweisen.

6. Messeinrichtung (2) nach einem der vorstehenden Ansprüche, **dadurch gekennzeichnet, dass** die Messeinrichtung (2) einen zweiten magnetisierbaren Messspulenkern (6) aufweist, der mit seinen Magnetflussdurchtrittsflächen (15) gegenüberliegend zu den Magnetflussdurchtrittsflächen (15) des von der Messspulenwicklung (7) umgriffenen ersten magnetisierbaren Messspulenkerns (6) angeordnet ist, wobei der magnetisierbare Prüfkörper (16) derart zwischen den Magnetflussdurchtrittsflächen (15) der zwei magnetisierbaren Messspulenkerne (6) angeordnet werden kann, dass der durch die Messspulenwicklung (7) erzeugte magnetische Fluss (14) durch die zwei magnetisierbaren Messspulenkerne (6) und den magnetisierbaren Prüfkörper (16) geführt und verlaufen kann.

7. Messeinrichtung (2) nach einem der vorstehenden Ansprüche, **dadurch gekennzeichnet, dass** die Messeinrichtung (2) eine magnetooptische Sensoreinrichtung (18) aufweist, mit welcher eine Magnetisierung des magnetisierbaren Prüfkörpers (16) optisch erfasst werden kann.

8. Messeinrichtung (2) nach einem der vorstehenden Ansprüche, **dadurch gekennzeichnet, dass** die Messspulenwicklung (7) aus mehradrigen Leitungen besteht, wobei die mehradrigen Leitungen gegeneinander elektrisch isoliert sind.

9. Verfahren (20) zur Ermittlung einer magnetischen Eigenschaft eines magnetisierbaren Prüfkörpers (16), wobei in einem Messschritt (23) der magnetisierbare Prüfkörper in einer Messposition relativ zu einem Messspulenkern mit einer den Messspulenkern umgreifenden Messspulenwicklung einer Messeinrichtung (2) angeordnet wird und mit einer Energieversorgungseinrichtung (3), die mit der Messeinrichtung (2) elektrisch leitend verbunden ist, durch die Messspulenwicklung (7) der Messeinrichtung (2) ein von der Energieversorgungseinrichtung (3) bewirkter Hochstromimpuls geführt wird, wobei mindestens ein zeitlicher Strom- und Spannungsverlauf durch die Messspulenwicklung (7) erfasst werden, und wobei in einem nachfolgenden Ermittlungsschritt (25) eine Kenngröße für eine magnetische Eigenschaft des Prüfkörpers (16) anhand des mindestens einen erfassten Strom- und Spannungsverlaufs ermittelt wird, indem der mit dem magnetisierbaren Prüfkörper erfasste Strom- und Spannungsverlauf für den magnetisierbaren Prüfkörper (16) und die Messeinrichtung (2) mit dem jeweiligen Verlauf eines Referenzstromverlaufs und Referenzspannungsverlaufs verglichen wird, wobei aus einer Differenz zwischen dem gemessenen Strom- und Spannungsverlauf und dem Referenzstrom- und Referenzspannungsverlauf die Kenngröße für die magnetische Eigenschaft des Prüfkörpers (16) ermittelt wird.

10. Verfahren (20) nach Anspruch 9, **dadurch gekennzeichnet, dass** der von der Energieversorgungseinrichtung (3) erzeugte und durch die Messspulenwicklung (7) geführte Hochstromimpuls so vorgegeben wird, dass ein in dem magnetisierbaren Prüfkörper durch den Hochstromimpuls erzeugter magnetischer Fluss an eine magnetische Sättigung des magnetisierbaren Prüfkörpers (16) angepasst ist.

11. Verfahren (20) nach Anspruch 9 oder Anspruch 10, **dadurch gekennzeichnet, dass** in einem Verlagerungsschritt (26) der magnetisierbare Prüfkörper (16) relativ zu Magnetflussdurchtrittsflächen (15) des Messspulenkerns (6) verlagert wird.

12. Verfahren (20) nach einem der Ansprüche 9 bis 11, **dadurch gekennzeichnet, dass** in einem Magnetfelderfassungsschritt (24) die mit einer magnetooptischen Sensoreinrichtung (18) erfassbare magnetische Flussdichte des Magnetfeldes an einer Oberfläche des Prüfkörpers (16) erfasst wird.

13. Messsystem (1) zur Messung magnetischer Eigenschaften und Kenngrößen des magnetisierbaren Prüfkörpers (16) mit einer Messeinrichtung (2) nach einem der vorstehenden Ansprüche 1 bis 8, wobei das Messsystem (1) eine Messverarbeitungseinrichtung (13) aufweist, die mit der Messeinrichtung (2) signalübertragend verbunden ist und mit der ein Verfahren (20) nach einem der Ansprüche 9 bis 12 durchführbar ist.

## Claims

1. Measuring device (2) for determining magnetic properties of a magnetisable test specimen (16), wherein the measuring device (2) comprises a measuring coil winding (7), a measuring coil core (6) and an energy supply device (3), wherein the measuring coil winding (7) surrounds the measuring coil core (6) and can be supplied with electrical energy by the energy supply device (3), and wherein the measuring device (2) comprises a sensor device (8), which is configured and adapted to detect at least one characteristic variable for the magnetic properties of the magnetisable test specimen (16), **characterised in that** the energy supply device (3) is configured and adapted in such a way that a high-current pulse can be generated by the energy supply device (3) and conducted through the measuring coil winding (7), **in that** the measuring coil core (6) comprises at least two magnetic flux passage surfaces (15) arranged at a distance from one another, wherein the magnetisable test specimen (16) can be arranged adjacent to the at least two magnetic flux passage surfaces (15) during a measuring process in such a way that the high-current pulse that can be conducted through the measuring coil winding (7) can cause a magnetic flux (14) through the measuring coil core (6) and the magnetisable test body (16), and **in that** the sensor device is configured and adapted in such a way that the sensor device (8) can be used to detect a time characteristic of electrical parameters of the measuring coil winding (7).

2. Measuring device (2) according to claim 1, **characterised in that** the measuring coil core (6) consists of a material with high magnetic permeability.

3. Measuring device (2) according to claim 1 or 2, **characterised in that** the magnetisable test specimen (16) is arranged movably at the magnetic flux passage surfaces (15).

4. Measuring device (2) according to any one of the preceding claims, **characterised in that** the measuring coil core (6) is U-shaped.

5. Measuring device (2) according to any one of the preceding claims, **characterised in that** the magnetic flux passage surfaces (15) of the measuring coil core (6) have a surface roughness with a mean roughness of less than 5 pm, preferably of less than 0.5 µm.

6. Measuring device (2) according to any one of the preceding claims, **characterised in that** the measuring device (2) comprises a second magnetisable measuring coil core (6), which is arranged with its magnetic flux passage surfaces (15) opposite the magnetic flux passage surfaces (15) of the first magnetisable measuring coil core (6) passed around by the measuring coil winding (7), wherein the magnetisable test specimen (16) can be arranged between the magnetic flux passage surfaces (15) of the two magnetisable measuring coil cores (6) in such a way that the magnetic flux (14) generated by the measuring coil winding (7) can be guided through and pass through the two measuring coil cores (6) and the magnetisable test specimen (16).

7. Measuring device (2) according to any one of the preceding claims, **characterised in that** the measuring device (2) comprises a magneto-optical sensor device (18) with which a magnetisation of the magnetisable test specimen (16) can be optically detected.

8. Measuring device (2) according to any one of the preceding claims, **characterised in that** the measuring coil winding (7) consists of multi-core leads, wherein the multi-core leads are electrically insulated from one another.

9. Method (20) for determining a magnetic property of a magnetisable test specimen (16), wherein in a measuring step (23) the magnetisable test specimen is arranged in a measuring position relative to a measuring coil core with a measuring coil winding of a measuring device (2) surrounding the measuring coil core and a high-current pulse caused by the energy supply device (3) is conducted through the measuring coil winding (7) of the measuring device (2) by means of an energy supply device (3), which is electrically conductively connected to the measuring device (2), wherein at least one current and voltage curve over time is detected by the measuring coil winding (7), and wherein in a subsequent determination step (25) a characteristic variable for a magnetic property of the test specimen (16) is determined on the basis of the at least one detected current and voltage curve by comparing the current and voltage curve recorded with the magnetisable test specimen for the magnetisable test specimen (16) and the measuring device (2) with the respective curve of a reference current curve and reference voltage curve, wherein the characteristic variable for the magnetic property of the test specimen (16) is determined from a difference between the measured current and voltage curve and the reference current and reference voltage curve.

10. Method (20) according to claim 9, **characterised in that** the high-current pulse generated by the energy supply device (3) and guided through the measuring coil winding (7) is predefined such that a magnetic flux generated in the magnetisable test specimen by the high-current pulse is adapted to a magnetic saturation of the magnetisable test specimen (16).

11. Method (20) according to claim 9 or claim 10, **characterised in that** in a displacement step (26), the magnetisable test specimen (16) is displaced relative to magnetic flux passage surfaces (15) of the measuring coil core (6) .

12. Method (20) according to any one of claims 9 to 11, **characterised in that** in a magnetic field detection step (24), the magnetic flux density of the magnetic field on a surface of the test specimen (16), which can be detected by a magneto-optical sensor device (18), is detected.

13. Measuring system (1) for measuring magnetic properties and characteristic variables of the magnetisable test specimen (16) having a measuring device (2) according to any one of the preceding claims 1 to 8, wherein the measuring system (1) comprises a measurement processing device (13), which is connected to the measuring device (2) in a signal-transmitting manner and can be performed using a method (20) according to any one of claims 9 to 12.

## Revendications

1. Dispositif de mesure (2) pour déterminer les propriétés magnétiques d'un corps d'essai magnétisable (16), le dispositif de mesure (2) présentant un enroulement de bobine de mesure (7), un noyau de bobine de mesure (6) et un dispositif d'alimentation en énergie (3), l'enroulement de bobine de mesure (7) entourant le noyau de bobine de mesure (6) et pouvant être alimenté en énergie électrique par le dispositif d'alimentation en énergie (3), et le dispositif de mesure (2) présentant un dispositif capteur (8), qui est configuré et adapté pour détecter au moins une grandeur caractéristique pour les propriétés magnétiques du corps d'essai magnétisable (16), **caractérisé en ce que** le dispositif d'alimentation en énergie (3) est configuré et adapté de telle sorte qu'une impulsion de courant élevé peut être générée avec le dispositif d'alimentation en énergie (3) et conduite à travers l'enroulement de bobine de mesure (7), **en ce que** le noyau de bobine de mesure (6) présente au moins deux surfaces de passage de flux magnétique (15) agencées à distance l'une de l'autre, le corps d'essai magnétisable (16) pouvant être agencé pendant une opération de mesure au voisinage des au moins deux surfaces de passage de flux magnétique (15) de telle sorte que l'impulsion de courant élevé pouvant être conduite à travers l'enroulement de bobine de mesure (7) peut provoquer un flux magnétique (14) à travers le noyau de bobine de mesure (6) et le corps d'essai magnétisable (16), et **en ce que** le dispositif capteur est configuré et adapté de telle sorte qu'une courbe temporelle de grandeurs caractéristiques électriques de l'enroulement de bobine de mesure (7) peut être détectée avec le dispositif capteur (8).

2. Dispositif de mesure (2) selon la revendication 1, **caractérisé en ce que** le noyau de bobine de mesure (6) est constitué d'un matériau à haute perméabilité magnétique.

3. Dispositif de mesure (2) selon la revendication 1 ou 2, **caractérisé en ce que** le corps d'essai magnétisable (16) est agencé de manière à pouvoir être déplacé sur les surfaces de passage de flux magnétique (15).

4. Dispositif de mesure (2) selon l'une quelconque des revendications précédentes, **caractérisé en ce que** le noyau de bobine de mesure (6) est conçu en forme de U.

5. Dispositif de mesure (2) selon l'une quelconque des revendications précédentes, **caractérisé en ce que** les surfaces de passage de flux magnétique (15) du noyau de bobine de mesure (6) présentent une rugosité de surface avec une valeur de rugosité moyenne inférieure à 5 pm, de préférence inférieure à 0,5 µm.

6. Dispositif de mesure (2) selon l'une quelconque des revendications précédentes, **caractérisé en ce que** le dispositif de mesure (2) présente un deuxième noyau de bobine de mesure magnétisable (6) qui est agencé avec ses surfaces de passage de flux magnétique (15) en face des surfaces de passage de flux magnétique (15) du premier noyau de bobine de mesure magnétisable (6) entouré par l'enroulement de bobine de mesure (7), le corps d'essai magnétisable (16) pouvant être agencé entre les surfaces de passage de flux magnétique (15) des deux noyaux de bobine de mesure magnétisables (6) de telle sorte que le flux magnétique (14) généré par l'enroulement de bobine de mesure (7) peut être guidé et s'écouler à travers les deux noyaux de bobine de mesure magnétisables (6) et le corps d'essai magnétisable (16).

7. Dispositif de mesure (2) selon l'une quelconque des revendications précédentes, **caractérisé en ce que** le dispositif de mesure (2) présente un dispositif capteur magnéto-optique (18) avec lequel une magnétisation du corps d'essai magnétisable (16) peut être détectée optiquement.

8. Dispositif de mesure (2) selon l'une quelconque des revendications précédentes, **caractérisé en ce que** l'enroulement de bobine de mesure (7) est constitué de lignes multiconductrices, les lignes multiconductrices étant isolées électriquement les unes des autres.

9. Procédé (20) de détermination d'une propriété magnétique d'un corps d'essai magnétisable (16) ; dans une étape de mesure (23), le corps d'essai magnétisable étant placé dans une position de mesure par rapport à un noyau de bobine de mesure avec un enroulement de bobine de mesure entourant le noyau de bobine de mesure d'un dispositif de mesure (2) et avec un dispositif d'alimentation en énergie (3), qui est relié de manière électriquement conductrice au dispositif de mesure (2), une impulsion de courant élevé provoquée par le dispositif d'alimentation en énergie (3) étant guidée à travers l'enroulement de bobine de mesure (7) du dispositif de mesure (2), au moins une courbe de courant et de tension temporelle étant détectée par l'enroulement de bobine de mesure (7), et, dans une étape de détermination suivante (25), une grandeur caractéristique pour une propriété magnétique du corps d'essai (16) étant déterminée à l'aide de l'au moins une courbe de courant et de tension détectée, en comparant la courbe de courant et de tension détectée avec le corps d'essai magnétisable pour le corps d'essai magnétisable (16) et le dispositif de mesure (2) à la courbe respective d'une courbe de courant de référence et d'une courbe de tension de référence, la grandeur caractéristique pour la propriété magnétique du corps d'essai (16) étant déterminée à partir d'une différence entre la courbe de courant et de tension mesurée et la courbe de courant et de tension de référence.

10. Procédé (20) selon la revendication 9, **caractérisé en ce que** l'impulsion de courant élevé générée par le dispositif d'alimentation en énergie (3) et guidée par l'enroulement de bobine de mesure (7) est prédéfinie de telle sorte qu'un flux magnétique généré dans le corps d'essai magnétisable par l'impulsion de courant élevé est adapté à une saturation magnétique du corps d'essai magnétisable (16).

11. Procédé (20) selon la revendication 9 ou la revendication 10, **caractérisé en ce que**, dans une étape de déplacement (26), le corps d'essai magnétisable (16) est déplacé par rapport à des surfaces de passage de flux magnétique (15) du noyau de bobine de mesure (6).

12. Procédé (20) selon l'une quelconque des revendications 9 à 11, **caractérisé en ce que**, dans une étape de détection de champ magnétique (24), on détecte la densité de flux magnétique du champ magnétique sur une surface du corps d'essai (16), qui peut être détectée avec un dispositif capteur magnéto-optique (18).

13. Système de mesure (1) pour la mesure de propriétés et de grandeurs caractéristiques magnétiques du corps d'essai magnétisable (16), avec un dispositif de mesure (2) selon l'une quelconque des revendications 1 à 8 précédentes, le système de mesure (1) présentant un dispositif de traitement de mesure (13) qui est relié au dispositif de mesure (2) de manière à transmettre des signaux et avec lequel un procédé (20) selon l'une quelconque des revendications 9 à 12 peut être mis en oeuvre.
